(19) **Europäisches Patentamt / European Patent Office / Office européen des brevets**

(11) **EP 1 816 240 A1**

(12) **EUROPEAN PATENT APPLICATION**
published in accordance with Art. 158(3) EPC

(43) Date of publication:
08.08.2007 Bulletin 2007/32

(51) Int Cl.:
*C30B 29/16* (2006.01)    *C30B 7/10* (2006.01)

(21) Application number: 05785696.5

(22) Date of filing: 21.09.2005

(86) International application number:
PCT/JP2005/017398

(87) International publication number:
WO 2006/038467 (13.04.2006 Gazette 2006/15)

(84) Designated Contracting States:
DE FR

(30) Priority: 01.10.2004 JP 2004290641
11.08.2005 JP 2005233202

(71) Applicants:
• Tokyo Denpa Co., Ltd.
Ota-ku
Tokyo 143-0024 (JP)
• Mitsubishi Chemical Corporation
Minato-ku
Tokyo 108-0014 (JP)

(72) Inventors:
• YOSHIOKA, Kenji
Tokyo 1430024 (JP)

• YONEYAMA, Hiroshi
Tokyo 1430024 (JP)
• MAEDA, Katsumi
Tokyo 1430024 (JP)
• NIIKURA, Ikuo
Tokyo 1430024 (JP)
• SATO, Mitsuru
Tokyo 1430024 (JP)
• ITO, Masumi,
Mitsubishi Chem. Gr. Sc. & Techn.
Yokohama-shi, Kanagawa 227-8502 (JP)
• ORITA, Fumio,
Mitsubishi chemical corporation
Tokyo 108-0014 (JP)

(74) Representative: Vossius & Partner
Siebertstrasse 4
81675 München (DE)

(54) **HEXAGONAL WURTZITE TYPE SINGLE CRYSTAL, PROCESS FOR PRODUCING THE SAME, AND HEXAGONAL WURTZITE TYPE SINGLE CRYSTAL SUBSTRATE**

(57) Provided is a single crystal with a hexagonal wurtzite structure which is useful as a substrate for various devices and has high purity and is uniform. The single crystal with a hexagonal wurtzite structure, which is obtained by a crystal growth on at least an m-plane of a columnar seed crystal and represented by AX (A representing an electropositive element and X representing an electronegative element) is **characterized in that** a variation in the concentration of a metal other than the electropositive element A and having a concentration of 0.1 to 50 ppm is within 100%.

**Description**

TECHNICAL FIELD

The present invention relates to a single crystal with a hexagonal wurtzite structure, a production process thereof, and a single crystal substrate with a hexagonal wurtzite structure.

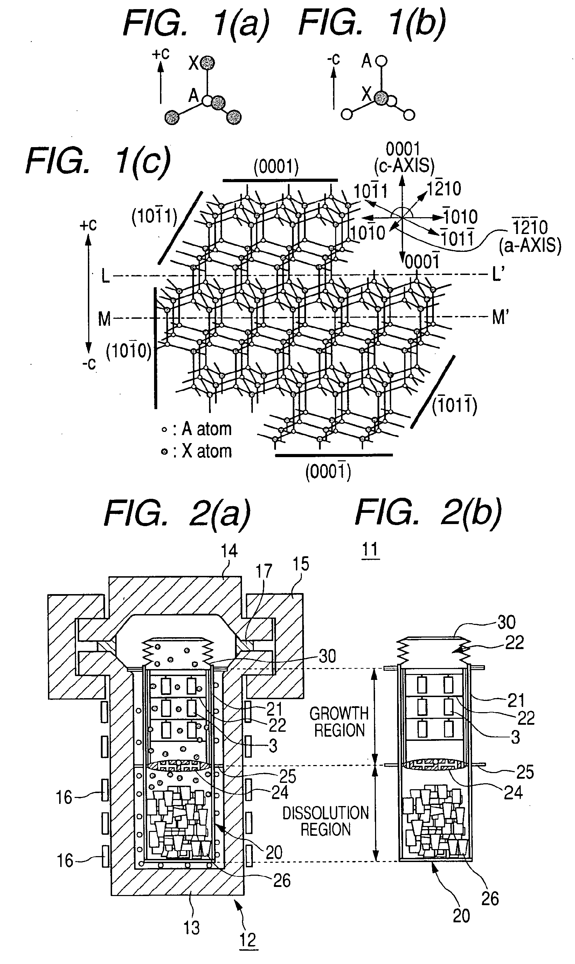

Hexagonal crystals have three a axes which make an angle of 120° within a regular hexagonal plane and one c axis which is vertical thereto, totally four crystallographic axes. A plane vertical to the c axis is called "c plane", a plane parallel to the c axis and any one of a-axes is "m plane", and a plane parallel to the c axis and vertical to any one of the a axes is called "a plane". Atomic arrangement of a crystal structure found in a compound represented by AX (wherein, A represents an electropositive element and X represents an electronegative element), that is, a wurtzite structure, among hexagonal crystal systems, is shown in FIG. 1. The A atom and X atom each has an arrangement close to the hexagonal close-packed structure. The A atom has four tetrahedrally-coordinated X atoms, while the X atom has four tetrahedrally-coordinated A atoms. In each tetrahedral cluster, a direction which is parallel to the c axis and along which A has, at directly thereabove, X is defined "+c" as illustrated in FIG. 1 (a) and a direction which is parallel to the c axis and in which X has, at directly thereabove, A is defined as "-c" as illustrated in FIG. 1 (b); and c planes which are vertical to the axis c and in the directions of +c and -c are discriminated by expressing them as (0001) plane and

[Chemical formula 1] (000$\bar{1}$) PLANE

respectively. When the crystal is cut along the c plane, the bond is cleaved only at a position L-L' or M-M' of FIG. 1(c) or equivalent position thereof so that in the (0001) plane, only element A appears, while in the

[Chemical formula 2] (000$\bar{1}$) PLANE

only element X appears from the surface. Single crystals after growth also have the same surface. Owing to such an atomic arrangement, a compound having a wurtzite structure has a polarity in the direction of the c axis. Examples of the compound known to be have a hexagonal wurtzite structure include, as well as zinc sulfide (ZnS) which is wurtzite, zinc oxide (ZnO), aluminum nitride (AlN), gallium nitride (GaN), and indium nitride (InN).

Growth methods of a single crystal with a hexagonal wurtzite structure include gas phase methods, liquid phase methods, and melt methods. The gas phase methods and melt methods have the drawbacks that crystals obtained thereby have a high defect density and these methods require a very high pressure and high temperature condition for growth. The liquid phase methods, on the other hand, feature that crystals of a high quality having a low defect density are available at a relatively low temperature. Of the liquid phase methods, Solvo-thermal method is suited for the growth of crystals having a low impurity concentration and a high quality. The term "Solvo-thermal method" is collectively used for a method of charging raw materials and seed crystals in a vessel for retaining a supercritical solvent, dissolving these raw materials and causing reprecipitation of them by making use of a temperature difference, and thus obtaining single crystals. The method using water as the solvent is called "hydrothermal synthesis", while the method using ammonia is called "ammonothermal method".

Of compounds having a hexagonal wurtzite type crystal structure, a zinc oxide (chemical formula of zinc oxide "ZnO" will hereinafter be used as the term having the same meaning as zinc oxide) single crystal, more specifically, a ZnO single crystal which has been used in various fields such as blue-violet or ultraviolet light emitting device (substrate therefor), surface acoustic wave (SAW), gas sensor, piezoelectric device, transparent conductor and varistor and has excellent functions; and a substrate using the single crystal will be described mainly. The single crystal with a hexagonal wurtzite structure according to the present invention is not however limited to ZnO.

An electronegative element which is one of two elements constituting the crystal having a hexagonal wurtzite structure is a molecular gas of nitrogen or oxygen or an element having volatility such as sulfur or selenium and it is difficult to keep a stoichiometric mixture ratio of the composition with an electropositive element at the time of crystal growth. The Solvo-thermal method is characterized in that it enables crystal growth in an environment containing an electronegative element component in a hermetically-sealed high pressure vessel. It is however difficult to prevent generation of a defect, that is, loss of an electronegative element in the crystal, even under this environment. Prevention of occurrence of problems resulting from this defect is therefore a theme common to crystals such as zinc sulfide (ZnS), zinc oxide (ZnO), aluminum nitride (AlN), gallium nitride (GaN) and indium nitride (InN).

A zinc oxide (ZnO) single crystal is a semiconductor which has a crystal structure of a hexagonal wurtzite compound as described above, is a direct transition type, and has a wide forbidden bandwidth (Eg: 3.37 eV). Since it has an extremely higher exciton binding energy (ZnO: 60 meV) than other semiconductor materials (GaN: 21 meV, ZnSe: 20 meV), it is expected as a highly efficient light emitting device material. Although a p type ZnO must be prepared for actualizing a light emitting device utilizing ZnO, ZnO easily generates defects such as oxygen deficiency and zinc in an interstitial site and tends to become not a p type but an n type.

Many research institutes are studying with a view to obtaining p type ZnO, and success in it is expected to cause a revolution in the worlds of photoelectronics and energy. Since a zinc oxide single crystal has a wurtzite crystal structure similar to that of GaN which has been industrialized several years ago as a blue-violet light emitting diode (LED) and has therefore a comparable lattice constant (lattice mismatch: about 2%), and there is a possibility of it being produced at a low cost in future, it has drawn attentions as a substrate for the growth of a GaN thin film instead of sapphire or SiC used mainly at present.

The following is a report on the growth of a ZnO single crystal.

The growth of a ZnO single crystal by hydrothermal synthesis is described in Non-patent Document 1. According to this method, a sintered ZnO is placed on the lower portion of a crystal growth vessel and a ZnO seed crystal is placed on the upper portion of the growth vessel. The vessel is then filled with an aqueous alkali solution composed of KOH and LiOH as a solvent (which will hereinafter be called "alkaline solvent"). Operation is performed in the growth vessel under the following conditions: growth temperature of 370 ~ 400°C and pressure of 700 ~ 1000 kg/cm$^2$. The growth of the ZnO single crystal is caused by performing the operation while adjusting the temperature at the lower portion of the growth vessel higher by 10 ~ 15°C than the temperature of the upper portion of the vessel.

When only an alkaline solvent is used as a growth solution for a ZnO single crystal, the growth is caused in a reducing atmosphere, an excess amount of Zn atoms becomes from ten and several ppm to twenty and several ppm and an conductivity becomes from $10^0$~ $10^{-2}$ 1/Ω·cm. This ZnO single crystal is not suited for an acoustoelectric effect device because of too high conductivity. As a result, hydrogen peroxide ($H_2O_2$) is added to the growth system in an attempt to cause the crystal growth in an oxygen atmosphere and obtain a highly purified ZnO single crystal.

Even a ZnO single crystal which has grown in the presence of the above-described $H_2O_2$ is not suited as an acoustoelectric effect device because its conductivity is as low as $10^{-8}$ ~ $10^{-10}$ 1/Ω·cm. The ZnO single crystal has therefore improved conductivity by depositing Zn vapor onto the surface of the thus-obtained ZnO single crystal, thereby increasing the Zn concentration on the surface excessively.

The improvement of the conductivity by the Zn vapor deposition as described above is however accomplished only in the proximity of the surface of the ZnO single crystal obtained by the vapor deposition, and the ZnO single crystal still has a problem that the single crystal as a whole lacks uniformity in the conductivity. In addition, such vapor deposition requires a large-scaled apparatus, which is disadvantageous from the standpoint of a manufacturing cost.

In Patent Document 1, there is described the manufacture of a piezoelectric semiconductor composed of a ZnO single crystal doped with a trivalent metal such as Al and having a diameter of about 1 inch at maximum. This semiconductor has been doped with 5 ~ 120 ppm of a trivalent metal and is said to have a conductivity of $10^{-3}$ ~ $10^{-6}$ 1/Ω·cm. The manufacturing method of a single crystal according to Patent Document 1 comprises placing a sintered ZnO raw material on a raw material filling portion at the lower portion of a growth vessel and a ZnO seed crystal on a crystal growth portion at the upper portion of the growth vessel; storing an alkaline solvent in the vessel; and adjusting the temperature inside the vessel so that the temperature of the raw material filling portion becomes higher than that of the crystal growth portion and causing the growth of the ZnO single crystal under a hydrothermal condition. This method is characterized in that $H_2O_2$ is mixed in the alkaline solution to form a ZnO single crystal and the resulting single crystal is doped with a trivalent metal to control the conductivity. The doping with a trivalent metal in the above-described manufacturing method makes it possible to improve the conductivity not only of a region in the vicinity of the crystal surface but also of the entire ZnO single crystal, thereby improving the uniformity of the conductivity.

According to Patent Document 1, the mobility (carrier mobility) of the ZnO single crystal is 30 cm$^2$/V·sec or greater, preferably 60 cm$^2$/V·sec or greater, which is however still on a low level as the property of a semiconductor and there is still room left for further improvement.

With regard to the ZnO single crystal, another presentation is made on the growth of a single crystal using a seed crystal changed in shape, for example, a seed crystal with a c plane having a large area or a seed crystal with a m plane having a large area (refer to Non-patent Document 2).

Non-patent Document 1: "Growth kinetics and morphology of hydrothermal ZnO single crystal", Noboru Sakagami, Masanobu Wada, Journal of the Ceramic Association, 82[8], 1974.

Non-patent Document 2: E. Oshima et al., Journal of Crystal Growth 260 (2004), 166-170

Patent Document 1: Japanese Patent Laid-Open No. Hei 6-90036

DISCLOSURE OF THE INVENTION

PROBLEMS THAT THE INVENTION IS TO SOLVE

The problem of the above-described prior art lies in difficulty in producing a highly-pure large-sized single crystal with a hexagonal wurtzite structure. Since conventionally known single crystals having a hexagonal wurtzite structure contain a large amount of impurities, they are not satisfactory from the viewpoint of the properties as a semiconductor, for example, conductivity and uniformity thereof.

When a single crystal with a hexagonal wurtzite structure is used as blue-violet or ultraviolet light emitting device (substrate therefor), surface acoustic wave (SAW), gas sensor, piezoelectric device, transparent conductor and varistor, it is the common practice to cut it from a predetermined direction into a single crystal plate having a thickness of from about several hundred $\mu$m to 5 mm and then provide it for use after surface processing and polishing. The single crystal plate obtained by cutting a single crystal to form a desired element will hereinafter be called "substrate". It is the common practice to obtain the substrate by cutting the crystal along a crystal plane vertical to a certain growth axis or with an inclination of several degrees therefrom. This inclination is made appropriate in accordance with the growth conditions in order to control the properties of the substrate typified by surface flatness mainly after the growth of a thin film. The substrate cut from the single substrate with an inclination of some angles therefrom in order to control the properties is therefore used for substantially the same purpose as that having a specific crystal plane.

In the conventional method for making a device, a c plane substrate substantially having a c plane in the surface thereof has been used mainly as a substrate cut from a single crystal with a hexagonal wurtzite structure. This c plane substrate is characterized in that since it is cut between A-X (at the position of L-L' or M-M' in FIG. 1 (c) or an equivalent position thereof) vertical to the c axis, a (0001) plane having a surface formed by A and

[Chemical formula 3] (000$\overline{1}$)PLANE

having a surface formed by X constitute both sides of the substrate. Which side of the substrate is utilized for the formation of a device thereover depends on the formation process of a target device.

In the conventional thin film growth, the optimization of the growth conditions has been performed based on the investigation while paying attention to the polarity of the surface on which the crystal growth is carried out. Thin film growth over the c plane vertical to the direction of the c axis is performed popularly because orderly presence, on the surface, of bonds cleaved from a single element in spite of different polarities facilitates control of the arrangement of the next element.

In the thin film growth, the polarity of the c plane which will be a substrate for growth can be selected readily. It is however impossible to select the polarity in the Solvo-thermal method, because growth of a large-sized single crystal from which a substrate is sliced occurs simultaneously on both sides of the crystal (seed crystal) which will be a seed. In other words, two regions, that is, a +c region which grows over the (0001) plane of the seed crystal and a -c region which grows over the

[Chemical formula 4] (000$\overline{1}$) PLANE

of the seed crystal inevitably exist in one single crystal.

According to Non-patent Document 1, in a ZnO single crystal which is a typical crystal having a hexagonal wurtzite structure, lithium (Li) in an alkaline solvent to be used for hydrothermal synthesis is contained more in the -c region than in the +c region, because in the crystal structure of ZnO, defects are present more in the -c region than +c region and therefore impurities are adsorbed to and incorporated in the -c region. Many of electronegative elements X constituting the surface in the -c region are molecular gases such as nitrogen and oxygen or elements having volatility such as sulfur and selenium so that generation of vacancy-related defects in the surface of crystal growth caused by the loss of element cannot be prevented easily.

When a c-plane substrate is obtained by cutting it from such a single crystal, a variation in the impurity concentration within the single crystal is reflected in a variation in the concentration among the C plane substrates owing to a difference in the cutting site, that is, whether it is cut from the -c region or the +c region. Moreover, in the a-plane substrate or the m-plane substrate, a variation in the impurity concentration inevitably occurs in the direction of the c-axis within one substrate plane. The variation in the impurity concentration adversely affects color and light absorption in the optical use and electrical properties such as dielectric constant when used for a dielectric substance, and carrier concentration and mobility in the semiconductor use. They may cause a variation among elements which will be provided as products so the variation in the impurity concentration must be avoided. Although the c-plane substrates can be used for different purposes after divided by regions, it is desired to control the impurity concentration to be uniform within one single crystal from the standpoints of productivity and difference in the required amount of substrates depending on the using purpose of the product. In the a-plane substrate or m-plane substrate, equalization of the in-plane distribution of the impurity concentration within one substrate is essential.

Single crystal and substrate with a hexagonal wurtzite structure, particularly, a mixed crystal of ZnO, GaN, InN and InGaN is expected to be useful for light emitting devices. In an element formed over the c-plane, a strong electric field is imposed in the crystal owing to the presence of polarity, leading to spatial separation between electrons and holes. This results in the problem that in the case of a light emitting device, an increase in the injection amount of carriers deteriorates the efficiency and causes a shift of a wavelength of an emitted light to the longer wavelength. Although it has been elucidated that the use of a non-polar surface, that is, m-plane or a-plane, in which electropositive elements and electronegative elements are present in an equal amount is useful for overcoming the problem, a large-sized substrate having a uniform impurity concentration is not available by the conventional crystal growth.

In GaN elements, a substrate having a GaN surface such as m-plane or a-plane has been obtained by ELO (Epitaxial Lateral Overgrowth) on the γ-plane sapphire substrate. In such a substrate, occurrence of defects attributable to a difference in the crystal system between sapphire and GaN and a difference in lattice constant adversely affect the characteristics of the element, causing a serious problem.

In Non-patent Document 2, there is described the crystal growth using seed crystals whose m-plane has a large area, but details of the crystal growth conditions are not included in Non-patent Document 2.

MEANS FOR SOLVING THE PROBLEMS

With the above-described problems of the prior art in view, the present inventors have carried out an extensive investigation. As a result, it has been found astonishingly that an unprecedentedly large single crystal with a hexagonal wurtzite structure can be obtained by using Solvo-thermal method under specific conditions, leading to the completion of the present invention. It has been elucidated that the single crystal with a hexagonal wurtzite structure thus obtained is an industrially very useful crystal with a markedly low impurity concentration and a small in-plane variation in the impurity concentration in the direction of the c-axis. In particular, it has been found that with regard to ZnO, an unprecedentedly large ZnO single crystal having a diameter of 2 inches or greater can be obtained and the ZnO single crystal thus obtained is an industrially very useful crystal with a markedly low concentration of trace metals in the crystal and a small in-plane variation in the direction of a c-axis.

In one aspect of the present invention, there is thus provided a single crystal with a hexagonal wurtzite structure which is obtained by the crystal growth on at least an m-plane of a columnar seed crystal and is represented by AX (wherein A represents an electropositive element and X represents an electronegative element), wherein the concentration of each of divalent and trivalent metals, among metals other than the electropositive element A, is 10 ppm or less and at the same time, a variation in the concentration of each of the divalent and trivalent metals is within 100%. In another aspect of the present invention, there is also provided a single crystal with a hexagonal wurtzite structure which is obtained by the crystal growth on at least an m-plane of a columnar seed crystal and is represented by AX (wherein A represents an electropositive element and X represents an electronegative element), wherein the concentration of each of iron (Fe), aluminum (Al) and magnesium (Mg), among metals other than the electropositive element A, is 10 ppm or less and at the same time, a variation in the concentration of each of iron (Fe), aluminum (Al) and magnesium (Mg) is within 100%. In a further aspect of the present invention, there is also provided a single crystal with a hexagonal wurtzite structure which is obtained by the crystal growth on at least an m-plane of a columnar seed crystal and is represented by AX (wherein A represents an electropositive element and X represents an electronegative element), wherein a variation in the concentration of a metal other than the electropositive element A and having a concentration of 0.1 ~ 50 ppm is within 100%. In a still further aspect of the present invention, there is also provided a single crystal substrate with a hexagonal wurtzite structure which has a substantial a-plane or substantial m-plane in the surface thereof and is represented by AX (wherein A represents an electropositive element and X represents an electronegative element), wherein the concentration of each of divalent and trivalent metals, among metals other than the electropositive element A, is 10 ppm or less and at the same time, a variation in the concentration of each of divalent and trivalent metals is within 100%. In a still further aspect of the present invention, there is also provided a single crystal substrate with a hexagonal wurtzite structure which has a substantial a-plane or a substantial m-plane in the surface thereof and is represented by AX (wherein A represents an electropositive element and X represents an electronegative element), wherein the concentration of each of iron (Fe), aluminum (Al) and magnesium (Mg), among metals other than the electropositive element A, is 10 ppm or less and at the same time, a variation in the concentration of each of iron (Fe), aluminum (Al) and magnesium (Mg) is within 100%. In a still further aspect of the present invention, there is also provided a single crystal substrate with a hexagonal wurtzite structure which has a substantial a-plane or substantial m-plane in the surface thereof and is represented by AX (wherein A represents an electropositive element and X represents an electronegative element), wherein a concentration distribution of a metal other than the electropositive element A and having a concentration, in the a-plane or m-plane, of 0.1 ~ 50 ppm is within 100%. The term "substantial a-plane or substantial m-plane" as used herein embraces a plane having an inclination of several degrees relative to the a-plane or m-plane, respectively, insofar as it will bring about a preferable result in surface flatness after a thin film is grown over the substrate. The single crystal substrate with a hexagonal wurtzite structure is preferably obtained by cutting the above-described single crystal with a hexagonal wurtzite structure. In a still further aspect of the present invention, there is also provided a production process of a single crystal with a hexagonal wurtzite structure, which comprises using a crystal formation apparatus having a raw material filling portion and a crystal growth portion, and adjusting the temperature of the crystal growth portion lower by at least 35°C than the temperature of the raw material filling portion to grow the single crystal with a hexagonal wurtzite structure in the crystal growth portion.

ADVANTAGES OF THE INVENTION

The single crystal with a hexagonal wurtzite structure can be used in a wide range of applications because it has a low impurity concentration and is excellent in uniformity of the impurity concentration. For example, a ZnO single crystal has a low impurity concentration and therefore has excellent transparency so that it can be used for optics application. In addition, since it is excellent in the uniformity of an impurity concentration, it is suited for use in dielectric devices and scintillators making use of the feature of it as a large-sized single crystal. In particular, in TOF PET (Time of Flight Positron Emission Tomography) which is expected to improve the detection accuracy of cancers by the tomographic observation of the whole body, a large-sized single crystal is used in the detector portion so that it is very important to equalize an impurity concentration in the crystal. The single crystal with a hexagonal wurtzite structure according to the present invention which features a small variation in the impurity concentration among c-plane substrates cut from the single crystal can be used without being influenced by the cutting site. Use of the m-plane or a-plane substrate is considerably useful because it reduces an in-plane variation in the impurity concentration, thereby enabling uniform detection properties.

The m-plane or a-plane substrate cut from the single crystal with a hexagonal wurtzite structure according to the present invention has a low impurity concentration, has almost no polarity and has excellent uniformity so that it is suited as a substrate for a device such as light emitting device (LED or the like). The single crystal with a hexagonal wurtzite structure and the substrate (especially, a mixed crystal of ZnO, GaN, InN and InGaN) thereof according to the present invention are expected to serve for light emitting devices. The use of the m-plane or a-plane substrate enables to avoid problems causing spatial separation of carriers which will otherwise occur by a strong electric field resulting from the polarity of the c-plane. When it is used as a high frequency oscillator device, its reduced impurities lead to an increase in the saturation mobility and improvement in the oscillation properties, while its excellent uniformity leads to uniform oscillation properties and improvement in reliability.

Use of the single crystal substrate with a hexagonal wurtzite structure having an m-plane or a-plane in the surface thereof is advantageous for joining with another crystal with a hexagonal wurtzite structure by a thin-film growth technology and a substrate of a new crystal having a m-plane or a-plane in the surface thereof can be obtained. For example, a substrate having an InGaN layer or GaN layer formed over a ZnO substrate can be obtained. By forming a GaN light emitting device over such a substrate, a practically great effect can be brought about while avoiding problems such as reduction in efficiency caused by an increase in the injection amount of carriers and shift of a wavelength of an emitted light to the longer wavelength. This combination can also be applied to an AlGaN layer. Moreover, it can be applied to a complex and multifunctional layer constitution such as AlGaInN layer via an InGaN layer over a ZnO substrate.

BRIEF DESCRIPTION OF THE DRAWINGS

[FIG. 1] FIG. 1 illustrates the atomic arrangement of a hexagonal wurtzite crystal structure.
[FIG. 2] FIG. 2 is a schematic view illustrating the structure of a single crystal growth apparatus for growing the ZnO single crystal of the present invention.
[FIG. 3] FIG. 3 is a cutaway view of a-plane and m-plane of a ZnO single crystal in Example 1.
[FIG. 4] FIG. 4 is the cutaway view of FIG. 3 viewed from the direction of the c axis.
[FIG. 5] FIG. 5 is a cutaway view of the m-plane of a ZnO single crystal in Comparative Example 1.
[FIG. 6] FIG. 6 is a cutout view of the m-plane of a ZnO single crystal in Example 2.
[FIG. 7] FIG. 7 is a cutaway view of the m plane of a ZnO single crystal in Example 3.

DESCRIPTION OF THE REFERENCE NUMERALS AND SIGNS

3: Seed crystal, 11: Single crystal growth apparatus, 12: Autoclave, 13: Vessel body, 14: Lid, 15: Fixing portion, 16: Heater, 17: Packing, 20: Growth vessel, 21: Flame, 22: Platinum wire, 24: Internal baffle plate, 25: External baffle plate, 26: Raw material, 30: Bellows

BEST MODE FOR CARRYING OUT THE INVENTION

The single crystal with a hexagonal wurtzite structure and the single crystal substrate with a hexagonal wurtzite structure according to the present invention will hereinafter be described specifically. The description on the following constituting elements will be made based on typical embodiments but the present invention is not limited to or by these embodiments. The range of a numerical value indicated by "~" as used herein means a range including the numerical values before and after "~" as the lower limit and upper limit, respectively.

The present invention relates to a novel single crystal with a hexagonal wurtzite structure and no particular limitation is imposed on the production process thereof. The production process however preferably includes a step of growing, from a columnar seed crystal, a crystal having, as the surface thereof, an m-plane. The single crystal is preferably produced using specific raw materials in accordance with strictly specified Solvo-thermal method. In particular, as described later, the single crystal with a hexagonal wurtzite structure according to the present invention is easily available by controlling temperature conditions during the crystal growth. This production process will next be described with ZnO as a preferred embodiment (typical example).

In order to produce, with high reproducibility, a ZnO single crystal which contains less impurities and is therefore highly pure, and has high quality, it is necessary to select only high-purity raw materials containing impurities as small as possible, minimize impurity incorporation during production steps, empirically setting the temperature and pressure conditions permitting crystal growth at an adequate growth rate, and adopting a structure of a reaction growth vessel capable of actualizing these points advantageously.

ZnO powders having higher purity are necessary as a raw material for growing a high quality ZnO single crystal and those having a purity of 99.999% or greater are usually required. In practice, such ZnO powders are sintered and then used as a direct raw material. Preparation of this sintered ZnO has a great influence on the growth of a single crystal. For the preparation of the sintered ZnO, it is recommended to use ZnO powders having an average particle size of 1 ~ 10 $\mu$m, charge the ZnO powders in a frame made of platinum before sintering, and then carrying out compression molding with a press or the like. This makes it possible to prevent generation of microcrystal during growing, thereby avoiding wasteful use of the raw material which will otherwise occur by the generation of microcrystal.

Although no particular limitation is imposed on the sintering temperature insofar it permits an adequately slow dissolution rate of the sintered ZnO, the sintering is usually performed preferably at a temperature of 1100°C ~ 1200°C in an oxidizing atmosphere. The lower sintering temperature unnecessarily increases the dissolution rate of the sintered ZnO and deteriorates the quality of the single crystal. Although no particular limitation is imposed on the sintering time insofar as it permits a desired dissolution rate, it is usually 1 hour ~ 2 hours. There is a possibility of the remaining ZnO powders being transported to the crystal growth portion by the thermal convection and adhering to the seed crystal so that a measure to avoid such a phenomenon must be taken. The sintered ZnO thus obtained and having a diameter $\phi$ of about 5 ~ 80 mm is placed appropriately in the raw material filling portion. Although no particular limitation is imposed on the shape of the sintered ZnO, it may be, for example, disc, cubic, or rectangular parallelepiped. From the standpoint of the uniformity of dissolution in a solvent, a spherical shape is desired.

For crystal growth, a columnar seed crystal is employed in the present invention. A seed crystal having a shape of square column, hexagonal column, cylindrical column or the like may be used freely. The crystal grows, following the shape of the seed crystal so that it is preferred to change the shape of the seed crystal, depending on the desired shape of the crystal. In the present invention in which a ZnO single crystal having, as the surface thereof, an m-plane having a longitudinal direction along the c axis (m-plane growth), use of a hexagonal columnar seed crystal or a long-stick-like seed crystal, that is, a rectangular parallelepiped seed crystal each longer in the c axis direction is preferred. The length of the side of the seed crystal in the c axis direction is preferably 1.1 times or greater, more preferably 2 times or greater, especially preferably 3 times the greater the length of another side.

The shape of a crystal grown from a seed crystal is influenced not only by the shape of the seed crystal but also atomic arrangement on the surface of the seed crystal as explained in Japanese Patent Laid-Open No. 2003-221298 using a hard sphere model. Even by using a seed crystal having, as the surface thereof, an a-plane, it is difficult to grow a crystal having, as the surface thereof, the a-plane Instead, a crystal having, as the surface thereof, an m-plane grows. Accordingly, a substrate having, as the surface thereof, the a-plane is available by cutting out the m-plane growth product. A desired ZnO single crystal substrate can therefore be obtained by using a crystal growth plane and a plane along which the crystal is sliced in combination as needed.

The seed crystal may be placed in any direction, but an angle between the c axis of the seed crystal and the direction of convection of a solvent is preferably 0 ~ 180° (with the proviso that 0° and 180° are excluded), especially preferably 60°~ 120°. Use of the seed crystal placed as described above makes it possible to yield a greater single crystal, because the ZnO single crystal grows while being decentered relative to the seed crystal.

Furthermore, two seed crystals joined together may be used as the seed crystal. In such a case, dislocation at the junction can be reduced by bringing them into contact while matching their c axis polarities to each other and then joining them by hydrothermal synthesis or utilizing a homoepitaxial effect. It is possible to obtain a seed crystal large in the direction of the c axis by joining the seed crystals together as described above even if the selective growth to the direction of the a axis occurs. In such a case, it is preferred to join the seed crystals while matching not only the c axis polarities but also the a axis polarities. As a result, it is preferred to join the seed crystals of the same shape together.

When seed crystals are joined together, the joined surface is preferably polished into mirror like smoothness. Polishing into smoothness at an atomic level is more preferred. Although no particular limitation is imposed on the polishing method, EEM (Elastic Emission Machining), for example, can be adopted for polishing. No particular limitation is imposed on an abrasive used for polishing. Examples include $SiO_2$, $Al_2O_3$, and $ZrO_2$, of which colloidal silica is preferred.

The ZnO single crystal is a hexagonal crystal, but its axial growth rate can be controlled by adjusting the growth conditions. The growth in the c axis direction can be promoted by the presence of potassium (K) during the growth. The growth can be promoted using the above-described KOH as a dissolving solution or a mineralizer. The growth in the a axis direction can be promoted preferably by the presence of lithium (Li). The growth can be promoted using LiOH as a dissolving solution or a mineralizer as described above.

In such a case, the crystal growth is effected in the presence of, as well as the ZnO raw material, an alkaline solvent usually composed of 1 ~ 6 mol/l of KOH and 1 ~ 3 mol/l of LiOH. Preferred concentrations of KOH and LiOH are, for example, 3 mol/l and 1 mol/1, respectively. With regard to the behavior when the alkali concentration is changed, the lower the LiOH concentration, the higher the growth rate in the direction of the c axis and the more frequently, needles appear. If necessary, the crystal growth is effected in the presence of $H_2O_2$ for the purpose of obtaining a high purity ZnO single crystal. $H_2O_2$ is usually added in an amount of 0.01 ~ 0.5 mole per liter of the alkaline solvent.

Next, sintered ZnO as a raw material, solvent and the like are charged into a growth vessel made of a highly heat resistant and highly anti-corrosive material, where crystal growth is effected. Among the highly heat resistant and highly anti-corrosive materials, platinum (Pt) and iridium (Ir) are preferred because they have a high strength and are excellent in stretchability and welding processability. A growth vessel of a first preferred embodiment is a vessel inside of which has been coated or plated with platinum (Pt) or iridium (Ir). A growth vessel of a second preferred embodiment has therein an independent crystal growth region surrounded by a liner made of an anticorrosive metal including platinum (Pt) or iridium (Ir). A growth vessel of a third preferred embodiment has therein a raw material filling portion filled with the sintered ZnO and a crystal growth portion having a wire or the like to retain ZnO seed crystal, which portions are partitioned by a baffle plate placed in a parallel direction in the vessel. Any portion in the growth vessel such as baffle plate and wire is preferably made of an anticorrosive metal including platinum (Pt) or iridium (Ir) or covered with such a material. A growth vessel of a fourth preferred embodiment has a seed crystal, which is composed of a relatively small ZnO single crystal, placed in the upper portion of the vessel (crystal growth portion when a baffle plate is employed). Such a baffle plate preferably has an aperture ratio of 5 ~ 15% (excluding 5%).

By interposing the raw material further between the raw material filling portion and the seed crystal holding portion, a transition rate of the crystal growth portion to a supersaturation state can be raised, whereby various demerits relating to the dissolution of the seed crystal can be prevented. An amount of the raw material to be supplied onto the baffle plate in this case is preferably 0.3 ~ 3 times the dissolution amount of ZnO at the crystal growth portion. In order to properly control the supersaturation degree in the growth vessel, a ratio of the capacity of the crystal growth portion to the capacity of the raw material filling portion is kept preferably within 1 ~ 5. A supersaturation degree exceeding 1.50 is not preferred because owing to a too high precipitation rate on the seed crystal, integrity inside of the growing crystal is deteriorated and at the same time, defects are introduced therein. Moreover, it increases the precipitation amount on the inner wall and the frame of the growth vessel so that when the precipitate becomes larger, the precipitate may be brought into contact with the resulting ZnO single crystal and disturb the growth of the single crystal. The supersaturation degree is set desirably within an appropriate range which enables achievement of a target growth rate and prevention of the introduction of crystal defects. It is usually 1.1 ~ 1.5, preferably 1.2 ~ 1.4.

The term "supersaturation" as used herein means a state where the amount of ZnO dissolved in a solvent exceeds the saturation level, while the term "supersaturation degree" means a ratio of a dissolved amount under a supersaturation state to a dissolved amount under a saturation state. In hydrothermal synthesis, it means a ratio of a dissolved amount of ZnO at the crystal growth portion under a supersaturation state as a result of the transport of ZnO from the raw material filling portion by means of thermal convection and a dissolved amount of ZnO at the crystal growth portion under a saturation state.

[Equation 1]

Supersaturation degree = (dissolved amount at crystal growth portion under a supersaturation state/dissolved amount at crystal growth portion under a saturation state)

This supersaturation degree can be controlled by changing and setting, as needed, a density of the ZnO raw material, an aperture ratio of a baffle plate, a temperature difference between the raw material filling portion and the crystal growth portion or the like.

In the growth vessel, a precipitate collection net may be provided above the place where the seed crystal is retained, that is, in the vicinity of the convergence point of the convection of a solvent. This precipitate collection net plays the following role. The convection of a solvent, that is, the transport flow of the solute runs toward a lower temperature region as it goes up in the growth vessel. The solute which is under a supersaturation state at the lower temperature region may undesirably be precipitated not only on the seed crystal but on a noble metal wire with which the seed crystal has been suspended, a flame for fastening this noble metal wire and even an inner wall of the growth vessel. In such a case, the precipitate collection net provided in the vicinity of the convergence point of the convection makes it possible to reverse the current of the solute, which has remained without precipitation on the seed crystal, with the inner wall at the ceiling of the vessel, thereby turning it downward, trap the microcrystal or precipitate from the transporting flow and at the same time, selectively precipitate the microcrystal on this collection net. Another embodiment in which the convection in the vicinity of the ceiling of the vessel can be reversed smoothly by a dome-like ceiling is preferably employed. The collection net is composed of an anticorrosive metal including platinum (Pt) or iridium (Ir) similar to the baffle plate and wire for suspending the seed crystal.

By the use of a growth vessel which has, sealed therein, an inner cylinder of a growth vessel such as a liner made of an anticorrosive metal including platinum (Pt) or iridium (Ir) and is placed in an autoclave or the like, incorporation of impurities in the system can be prevented completely. In such a case, it is preferred to charge an adequate amount of a hydraulic medium between the liner made of an anticorrosive metal including platinum (Pt) or iridium (Ir) and the autoclave so that the pressure therebetween becomes almost equal to that inside the liner. Although the size of the autoclave is no limited, use of a medium-size autoclave having a size of $\phi200 \times 3000$ mm facilitates preparation of a zinc oxide (ZnO) single crystal having a diameter of about 2 inches. As the hydraulic medium, any substance is usable insofar as it is weakly corrosive at high temperatures and pressures. Distilled water is preferred as the medium. The hydraulic medium generates a pressure at the crystal growth temperature, depending on the filling ratio relative to the internal space (which will hereinafter be called "free internal space") remaining when the growth vessel is placed in the autoclave. It functions to protect the growth vessel by adjusting the filling ratio of the hydraulic medium to make the pressure generated by the hydraulic medium equal to or a little higher than the pressure in the growth vessel. When distilled water is used as the hydraulic medium while employing the above-described solvent and solvent concentration, the filling ratio is preferably adjusted to about 60 ~ 90% of the free internal space of the autoclave.

It is also preferred to provide a pressure controlling portion equipped with means capable of adjusting the above-described difference between the pressure inside the growth vessel and that inside the autoclave at high temperatures and pressures during the crystal growth. As such a pressure controlling portion, for example, an expandable and contractible bellows mounted so as to hermetically seal the inside of the growth vessel therewith is preferred.

The growth of a ZnO single crystal can be performed by placing the above-described autoclave in a heating furnace, and elevating the temperature of the above-described growth vessel, thereby heating the crystal growth portion and the raw material filling portion to a predetermined temperature. The alkaline solvent is charged in an amount of about 60 ~ 90% of the free space in the growth container, that is, the space remaining after the sintered ZnO, baffle plate and the like are placed in the container. The growth is conducted preferably under a supercritical state at high temperatures and pressures (usually 300 ~ 400°C, 500 ~ 1000 atm). By setting the temperature of the crystal growth portion lower by about 15 ~ 50°C than that of the raw material filling portion, the convection occurs and the raw material which has dissolved at the dissolution region goes up to the growth portion, where it precipitates on the seed crystal and crystal growth occurs. When a temperature difference between the dissolution region and growth region is too small, a growth rate becomes too slow. When the temperature difference is too large, on the other hand, defects such as needles occur frequently.

The present inventors have found that an increase in a temperature difference between the crystal growth portion and the raw material filling portion when crystal growth is performed the m-plane of the seed crystal tends to facilitate formation of a high-quality crystal containing fewer impurities. They have also found that an increase in the temperature difference also brings about an industrial advantage by increasing a growth rate, thereby improving the productivity. An increase in the temperature difference to raise the growth rate usually increases the incorporation amount of impurities in the growing crystal so that according to the technological common knowledge, crystal growth is performed while lowering a temperature difference and decreasing a growth rate. In the production process of the present invention, on the other hand, the temperature of the crystal growth portion is made lower by at least 35°C, preferably at least 40°C than the temperature of the raw material filling portion. Such a temperature control enables production of a single crystal with fewer impurities, which is a preferred embodiment of the present invention. Because of the above-described reason, the temperature difference is preferably 50°C at a maximum. A decrease in the temperature difference between the crystal growth portion and the raw material filling portion to less than 35°C during adjustment of the difference is permissible.

With regard to the details of the crystal growth temperature at the crystal growth portion and raw material filling portion, it is preferred to set the crystal growth portion at 300 ~ 360°C and the raw material filling portion at 340 ~ 400°C. Under this condition, steady operation is continued for 30 ~ 200 days to grow the crystal. The heating furnace is then switched off to decrease the temperature to room temperature and the ZnO single crystal is taken out. The single crystal mass thus obtained can be washed with hydrochloric acid (HCl), nitric acid ($HNO_3$) or the like.

A ZnO single crystal having an unconventionally large diameter as large as 5 cm or greater is usually available in accordance with the above-descried process. Although no particular limitation is imposed on this size, a crystal having a diameter of about 15 cm can be produced in theory.

In the ZnO single crystal according to the present invention, a variation in the concentration of metals which are other than zinc and have a concentration of 0.1 ~ 50 ppm is preferably within 100%. The variation in the concentration of metals other than zinc is more preferably within 80%, still more preferably within 60%, especially preferably within 50%.

The metals other than zinc are typically divalent or trivalent metals, more specifically, iron, aluminum and magnesium. The concentration of each of the divalent and trivalent metals in the ZnO single crystal of the present invention is 10 ppm or less and a variation in it is within 100%. The concentration of each of iron, aluminum and magnesium in the ZnO single crystal according to another invention is 10 ppm or less and a variation in it within 100%. The concentration of each of the divalent and trivalent metals is more preferably 5 ppm or less, more preferably 2 ppm or less, especially preferably 1.5 ppm or less, most preferably 1.3 ppm or less. A variation in the concentration is preferably within 100%, more preferably within 80%, still more preferably within 60%, especially preferably within 50%.

The "variation in the concentration" as used herein can be determined in accordance with the below-described calculation formula based on concentrations of a metal (which will hereinafter be called "metal M") other than zinc measured in plural regions, more specifically, in at least three arbitrary regions. In a single crystal with a hexagonal wurtzite structure having a polarity in the direction of the c axis, a difference in impurity concentration usually tends to appear in the direction of the c axis so that measurement is conducted in a plurality of regions in the direction of the c axis. In this case, with supposition of a plane vertical to the c axis which passes through the center of the crystal, a substantially equal number of measurement regions are selected from symmetric regions with respect to the plane. When the number of the measurement regions is odd, measurement is conducted with one of the regions as a main. The concentration of each metal can be measured by the ordinarily employed method such as ICP-MS or GDMS. More specifically, the concentration can be measured in accordance with the method as described in the below-described Examples.

[Equation 2]

$$D(\%) = ([M]_{max} - [M]_{min}) / [M]_{mean} \times 100$$

wherein, each symbol has the following meaning:

D: variation in concentration
$[M]_{max}$: maximum concentration of metal M in a plurality of regions
$[M]_{min}$: minimum concentration of metal M in a plurality of regions
$[M]_{mean}$: mean concentration of metal M in a plurality of regions

In the single crystal with a hexagonal wurtzite structure represented by AX (wherein, A represents an electropositive element and X represents an electronegative element) according to the present invention, there is a marked tendency of suppressing the variation particularly in the concentration of divalent and/or trivalent metals other than the electropositive element A in the single crystal. The kind of the divalent or trivalent metal is not particularly limited. Metals which are present mainly in the single crystal with a hexagonal wurtzite structure represented by AX (wherein, A represents an electropositive element and X represents an electronegative element) and other than the electropositive element A are iron (Fe), nickel (Ni), manganese (Mn) and chromium (Cr), each derived from the vessel, and aluminum (Al), cadmium (Cd), lead (Pb), magnesium (Mg) and calcium (Ca), each derived from the raw material. Contents of alkali metals and alkaline earth metals are preferably as small as possible because they have a large diffusion rate in the crystal and may cause contamination of apparatuses used during a device manufacturing step.

In the ZnO single crystal of the present invention, the concentration of each of divalent and trivalent metals other than zinc which is the electropositive element A is preferably 1.3 ppm or less, more preferably 1.0 ppm or less, especially preferably 0.8 ppm or less. Reduction of the concentration of a divalent or trivalent metal may lead to advantages such as improvement in the transparency of the single crystal and high mobility.

In the ZnO single crystal of the present invention, the concentration of iron (Fe) is preferably 1.3 ppm or less, more preferably 1.0 ppm or less, especially preferably 0.8 ppm or less.

In the ZnO single crystal of the present invention, the concentration of aluminum (Al) is preferably 0.5 ppm or less, more preferably 0.45 ppm or less, especially preferably 0.4 ppm or less.

In the ZnO single crystal of the present invention, the concentration of magnesium (Mg) is preferably 0.1 ppm or less, more preferably 0.08 ppm or less, especially preferably 0.06 ppm or less. No particular limitation is imposed on the lower limit of the concentration of a divalent or trivalent metal other than zinc and it is preferably as small as 0 unless otherwise a special function such as conductivity is imparted to the crystal.

According to Non-patent Document 1, in a ZnO crystal, lithium (Li) in an alkaline solvent used in hydrothermal synthesis is contained in a larger amount in a -c region than in a +c region, because in the crystal structure of ZnO, a larger number of defects are contained in the -c region than the +c region and therefore, impurities tend to be adsorbed to and incorporated in the -c region. However, since the amount of metals other than zinc and incorporated in the growing crystal was as large as several tens ppm under the condition of hydrothermal synthesis of a ZnO single crystal according to the conventional report so that the unevenness of the metal distribution between the -c region and the +c region, which is observed in the ZnO single crystal of the present invention as represented by the above-described equation, was not confirmed. In the ZnO single crystal of the invention, on the other hand, incorporation of the impurities is avoided as much as possible by using a high-purity raw material and a growth vessel made of a proper material and limiting crystal growth conditions to, for example, m-plane growth, resulting in a stable distribution of the trace metal components other than zinc.

The above-described production process makes it possible to stabilize the distribution of trace metal components during the crystal growth. Based on this, it is possible to suppress a variation in the concentration of trace metal elements by doping, for example, by incorporating trace metal components in the raw material.

In the present invention, there is provided a single crystal substrate with a hexagonal wurtzite structure which has a substantial a-plane or substantial m-plane in the surface thereof and is represented by AX (wherein A represents an electropositive element and X represents an electronegative element), wherein the concentration of each of divalent and trivalent metals, among metals other than the electropositive element A, is 10 ppm or less and at the same time, a variation in the concentration of each of divalent and trivalent metals is within 100%. In the present invention, there is also provided a single crystal substrate with a hexagonal wurtzite structure which has, as the surface thereof, a substantial a-plane or a substantial m-plane and is represented by AX (wherein A represents an electropositive element and X represents an electronegative element), wherein the concentration of each of iron (Fe), aluminum (Al) and magnesium (Mg), among metals other than the electropositive element A, is 10 ppm or less and at the same time, a variation in the concentration of each of iron (Fe), aluminum (Al) and magnesium (Mg) is within 100%. In the present invention, there is also provided a single crystal substrate with a hexagonal wurtzite structure which has, as the surface thereof, a substantial a-plane or a substantial m-plane and is represented by AX (wherein A represents an electropositive element and X represents an electronegative element), wherein a variation in the concentration of a metal other than the electropositive element A and having a concentration of from 0.1 to 50 ppm in the a-plane or m-plane is within 100%. The single crystal substrate with a hexagonal wurtzite structure according to the present invention is preferably obtained by cutting out the above-described single crystal with a hexagonal wurtzite structure. Accordingly, the specific metals, concentrations, and variation in the concentration of each of the "metals other than positive element A" and/or "divalent and trivalent metals" in the single crystal substrate with a hexagonal wurtzite structure according to the present invention are similar to those specified in the single crystal with a hexagonal wurtzite structure according to the present invention. The cutting out method is not particularly limited and it can be selected as needed from ordinarily employed cutting out methods of a single crystal. It is the common practice to cut a single crystal into a substrate along a crystal plane vertical to a certain growth axis or with several degrees inclined relative to the crystal plane. The inclination is made appropriate according to the growth conditions mainly in order to improve the properties typified by flatness of the surface after thin film growth. The substrate inclined with such an intention is used for the same purpose as a substrate having substantially a particular crystal plane. The degree of inclination is selected from a range of 5° or less, preferably from a range of 2° or less, more preferably from a range of 1° or less.

Use of a single crystal substrate with a hexagonal wurtzite structure and having, as the surface thereof, an m-plane or p-plane is advantageous for joining with another crystal having the same hexagonal wurtzite structure by a thin film formation technology and it enables formation of a substrate of a new crystal having, as the surface thereof, an m-plane or a-plane. For example, it is possible to obtain a substrate having an InGaN layer or GaN layer formed over a ZnO substrate. Moreover, by forming a light emitting device thereover, problems such as deterioration in efficiency due to an increase in carrier injection and shift of a wavelength of an emitted light to the longer wavelength can be avoided, whereby a practically great effect can be attained. The above-described combination can also be applied to an AlGaN layer over a GaN substrate. Moreover, it can be applied to a complex and multifunctional layer constitution such as AlGaInN layer over the ZnO substrate via an InGaN layer.

EXAMPLE 1

The characteristics of the present invention will hereinafter be described more specifically by Examples and Comparative Examples. Materials, using amount and ratio of the materials, details of the treatment, treatment procedures and the like shown in the below-described examples can be changed as needed without departing from the scope of the present invention. The scope of the present invention should not be construed as limited to the specific examples described below.

(Explanation of apparatus)

A ZnO single crystal was obtained using a single crystal growth apparatus having a structure as shown in the schematic view of FIG. 2. The single crystal growth apparatus 11 shown in FIG. 2 comprises an autoclave 12 which can add, to the inside thereof, a temperature and a pressure required for the growth of the ZnO single crystal and a growing vessel 20 to be used while being housed in the autoclave 12. The autoclave 12 has a hermetically sealed structure in which a lid 14 is placed via a packing 17 on a body of the autoclave 12 made of, for example, a high tension steel composed mainly of iron and they are firmly fixed by a fixing member 15. The growth vessel 20 to be used while being housed in the autoclave 12 is made of platinum (Pt) and it has a substantially cylindrical shape. A bellows 30 serving as a pressure controlling portion is installed to the upper portion of the growth container to hermetically seal the inside of the growth vessel 20.

In such a single crystal growth apparatus 11, the growth of a ZnO single crystal is effected by suspending a hexagonal columnar ZnO seed crystal 3 on the upper side in the growth vessel 20 by the aid of a frame 21 and a platinum lead 22 and growing the seed crystal 3 with a rawmaterial 26 placed beneath the seed crystal. Between the ZnO seed crystal 3 and the raw material 26, an internal baffle plate 64 is provided for controlling the thermal convection. By this internal baffle plate 24, the inside of the growth vessel 20 is partitioned into a dissolution region and a growth region. The internal baffle plate 24 has a plurality of apertures. The opening area of the baffle plate 24 determined by the number of the apertures is set at 10%. The convection amount from the dissolution region to the growth region can be controlled by the opening area so that this area has an influence on the crystal growth rate. An external baffle plate 25 is provided outside the growth vessel 20. The convection outside the growth vessel 20 is limited by this external baffle plate 25, whereby a temperature difference necessary for the growth of the seed crystal 3 can be ensured between the regions in the growth vessel 20.

By using the single crystal growth apparatus 11 as described above, a ZnO single crystal having a m-plane in the surface thereof can be grown from a hexagonal columnar seed crystal in accordance with hydrothermal synthesis. In the growth vessel 20 having almost no impurities mixed therein, a ZnO single crystal having a diameter suited for industrial use can be obtained by properly selecting the number of growing days depending on its application.

(Example 1)

After ZnO powders having a purity of 99.9999% were compacted in a molding vessel and sintered at 1100°C for 24 hours, the solid thus obtained was filled in the growth vessel 20. Purified water in which 1 mol/l of LiOH and 3 mol/l of KOH had been dissolved as a mineralizer was poured in 80% of the free capacity of the growth vessel 20 and then 0.05 mol/l of $H_2O_2$ was poured therein further. The growth vessel 20 and bellows were welded to completely seal the growth vessel 20. For the thermal conductivity between the autoclave 12 ($\phi$200 x 300 mm) and the growth vessel 20, purified water was filled therein in an amount of 80% of the free capacity. The autoclave 12 comprising a vessel body 13 and a lid 14 was made airtight by placing the lid 14 on the vessel body 13 via a packing 17 and fixing them with a fixing member 15.

The dissolution region (having the same meaning as the raw material filling portion, which will equally apply hereinafter) and the growth region (having the same meaning as the crystal growth portion, which will equally apply hereinafter) were then heated by a heater 16. Upon heating, the temperature of the dissolution region was kept higher by 15 to 50°C than the temperature of the growth region, and the heating was performed to give the final temperatures of about 360°C in the dissolution region and about 310°C in the growth region. The raw material dissolved at the dissolution region went up by the convection and was then precipitated near the columnar seed crystal 3 (the length of the side in the c-axis direction was three times as much as that of another side) in the growth region, whereby the seed crystal was grown into a ZnO single crystal. Without changing the state, the steady operation was continued for 60 days to grow the seed crystal at a growth rate of about 0.2 mm/day each in the direction of the c axis and the a axis. After the temperature and pressure in the system were returned to room temperature and atmospheric pressure, the ZnO single crystal having a diameter of about 5 cm was taken out.

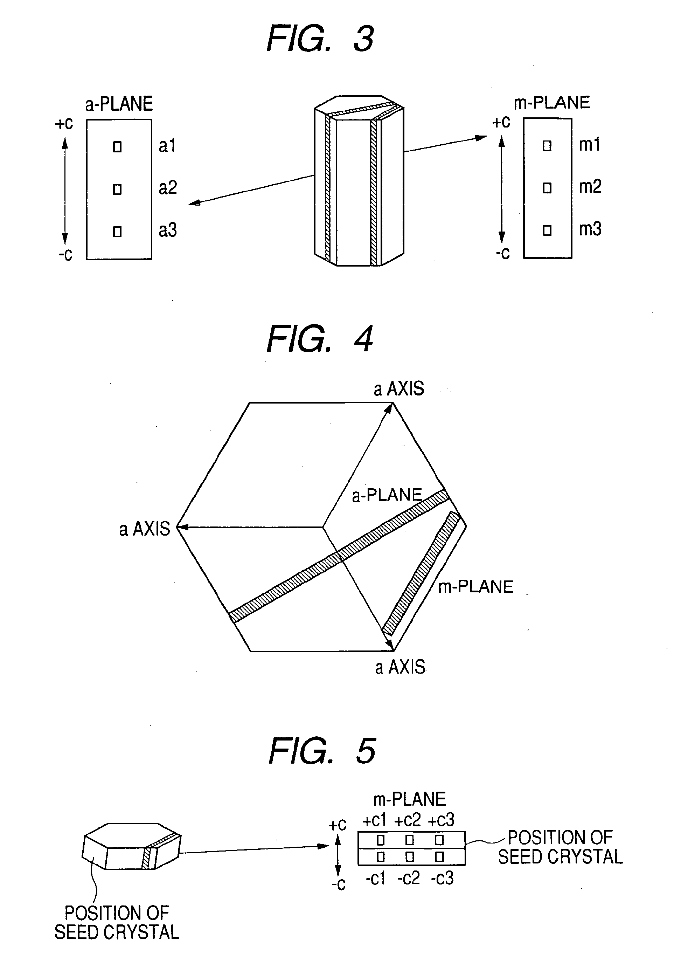

The ZnO single crystal thus obtained was analyzed by the following method. FIG. 3 is a cross-sectional view of each of the m-plane and a-plane cut from the ZnO single crystal in which designations of the growth regions are included. FIG. 4 is a cutaway view of FIG. 3 viewed from the direction of the c axis. After the surface of each sample obtained by cutting out the ZnO single crystal along this plane was washed with dilute nitric acid and distilled water, it was dissolved in nitric acid and hydrochloric acid. The solution thus obtained was quantified by a standard addition method using an ICP-QMS ("HP4500", product of Yokogawa Analytical Systems). The detection limit of each metal was 0.01 ppm. The measurement results of the metal concentrations in growth regions (m1 ~ m3, a1 ~ a3) along the direction of the c axis of each plane and variations in the concentration are shown in Table 1. Divalent and trivalent elements whose measurement values all exceeded the detection limit were Fe, Al, Mg and Cd and their content concentrations were each 1.3 ppm or less and their variations in the concentration were 50% or less. The analysis results of three metals Fe, Al and Mg which are each a divalent or trivalent metal are shown in Table 1. These analysis results suggest that the concentration of Fe is 1.3 ppm or less, that of Al is 0.5 ppm or less and that of Mg is 0.1 ppm or less and their variation within the same plane is within 100%.

(Comparative Example 1)

In a similar manner to Example 1 except for the use of a flat plate seed crystal (having a length of the side in the direction of the c axis 0.02 time as much as that of another side) as the seed crystal, crystal growth was effected to yield a hexagonal plate like crystal. FIG. 5 is a cross-sectional view of the hexagonal plate like crystal cut along the m-plane in which the designations of growth regions are included. The growth regions on the +c side viewed from the position of the seed crystal are +c1 ~ +c3, while the growth regions on the -c side viewed from the position of the seed crystal are -c1 ~ -c3. The samples thus obtained were analyzed in a similar manner to that employed in Example. The concentrations of Fe and Mg were 1.3 ppm or less and 0.1 ppm or less, respectively, but the concentration of Al was 0.5 ppm or greater. A variation in the concentration of each of Fe and Al within the same plane exceeded 100%.
[Table 1]

| | Region | Fe concentration (ppm) | Variation in Fe concentrations (%) | Al concentration (ppm) | Variation in Al concentrations (%) | Mg concentration (ppm) | Variation in Mg concentrations (%) |
|---|---|---|---|---|---|---|---|
| Ex. 1 | m1 | 0.48 | 53.6 | 0.08 | 44.4 | 0.03 | 30.0 |
| | m2 | 0.13 | | 0.07 | | 0.03 | |
| | m3 | 0. 47 | | 0.12 | | 0.04 | |
| | a1 | 0.21 | 37.5 | 0.13 | 14.3 | 0.04 | 0.0 |
| | a2 | 0.14 | | 0.14 | | 0.04 | |
| | a3 | 0.21 | | 0.15 | | 0.04 | |
| Comp. Ex. 1 Comp. Ex. 1 | +c1 | 0.38 | 118.2 | 0.12 | 130.0 | 0.04 | 26.7 |
| | +c2 | 0.29 | | 0.12 | | 0.04 | |
| | +c3 | 0.40 | | 0.13 | | 0.04 | |
| | -c1 | 1.0 | | 0.54 | | 0.03 | |
| | -c2 | 1.1 | | 0.56 | | 0.03 | |
| | -c3 | 0.94 | | 0.56 | | 0.03 | |

(Example 2)

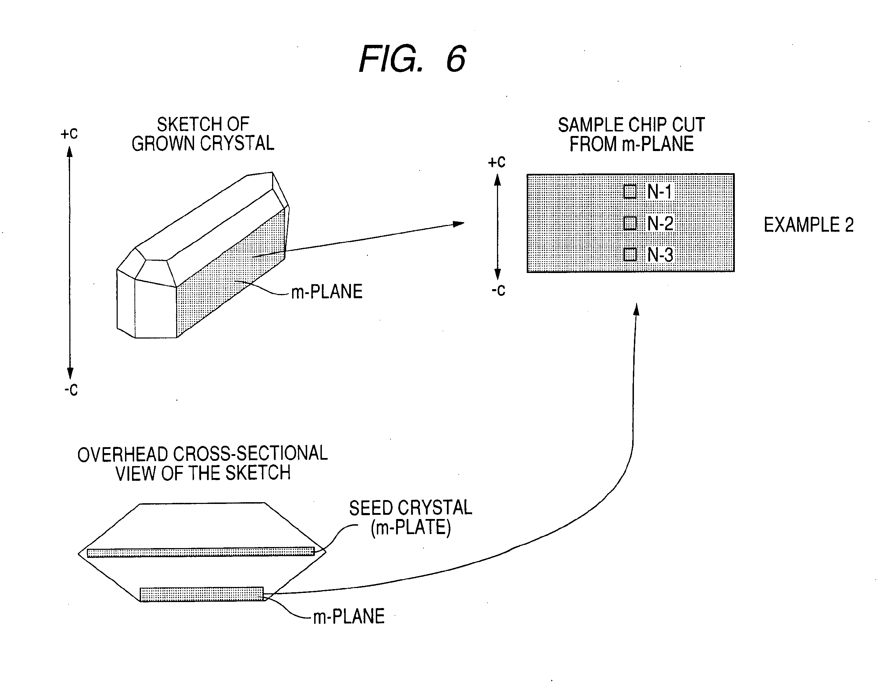

In a similar manner to Example 1 except that a final temperature difference between the raw material filling portion and crystal growth portion was set at 45°C, crystal growth of ZnO was performed. Described specifically, the temperature of the dissolution region was made greater by 35 to 45°C than the temperature of the growth region and heating was conducted to give the final temperature of the dissolution region of 390°C and that of the growth region of about 345°C. As a result, a crystal having a size of 60 mm (a) $\times$ 10 mm (m) $\times$ 20 mm (c) and having high transparency was obtained (in which, a, m and c represents the directions of respective axes). Analysis results of metal concentrations in regions N-1 to N-3 of the sample cut in FIG. 6 by a similar method to that employed in Example 1 are shown in Table 2. The results suggest that the concentration of Fe is 1.3 ppm or less, that of Al is 0.5 ppm or less and that of Mg is 0.1 ppm or less and a variation in the concentration within the same plane is within 100%.

(Example 3)

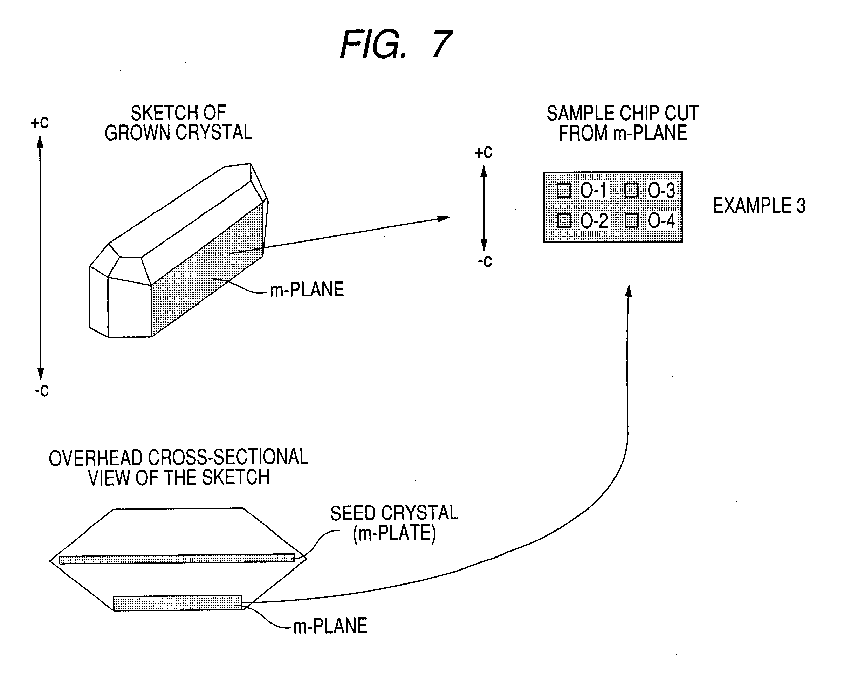

In a similar manner to Example 1 except that a final temperature difference between the raw material filling portion and crystal growth portion was set at 17°C, crystal growth of ZnO was performed. Described specifically, the temperature of the dissolution region was made greater by from 10 to 20°C than the temperature of the growth region and heating was conducted to give the final temperature of the dissolution region of 355°C and that of the growth region of about 338°C. As a result, a crystal having a size of 28 mm (a) $\times$ 11.5 mm (m) $\times$ 14 mm (c) and colored in green was obtained (in which, a, m and c represents the directions of respective axes). Analysis results of metal concentrations in regions O-1 to O-4 of the sample cut as in FIG. 7 by a similar method to that employed in Example 1 are shown in Table 2. The results suggest that the variation in each metal concentration within the same plane was within 100%, but the sample contained Fe, Al and Mg in a relatively large amount.
[Table 2]

| | Temperature difference | Region cut from m-plate | Fe concentration (ppm) | Variation in Fe concentrations (%) | Al concentration (ppm) | Variation in Al concentrations (%) | Mg concentration (ppm) | Variation in Mg concentrations (%) |
|---|---|---|---|---|---|---|---|---|
| Ex.2 | 45°C | N-1 | 0.72 | | 0.28 | | 0.05 | |
| | | N-2 | 0.61 | 60.5 | 0.18 | 74.1 | 0.05 | 18.8 |
| | | N-3 | 1.1 | | 0.39 | | 0.06 | |
| Ex. 3 Ex. 3 | 17°C | O-1 | 2.1 | | 0.54 | | 0.12 | |
| | | O-2 | 1.6 | 42.4 | 0.56 | 3.6 | 0.13 | 7.8 |
| | | O-3 | 1.5 | | 0.56 | | 0.13 | |
| | | O-4 | 1.4 | | 0.54 | | 0.13 | |

The invention has been described in detail with reference to specific embodiments thereof. It will be apparent to those skilled in the art that various changes and modifications can be made therein without departing from the spirit and scope thereof.

This application is based on Japanese Patent Application filed on October 1, 2004 (Application No. 2004-290641) and Japanese Patent Application filed on August 11, 2005 (Application No. 2005-233202), the contents thereof being herein incorporated by reference.

INDUSTRIAL APPLICABILITY

According to the invention, a single crystal with a hexagonal wurtzite structure which has a low impurity concentration and is excellent in uniformity of the impurity concentration can be provided.

**Claims**

1. A single crystal with a hexagonal wurtzite structure, which is obtained by a crystal growth on at least an m-plane of a columnar seed crystal and is represented by AX (wherein A represents an electropositive element and X represents an electronegative element), wherein the concentration of each of divalent and trivalent metals, among metals other than the electropositive element A, is 10 ppm or less, and a variation in the concentration of each of divalent and trivalent metals is within 100%.

2. The single crystal with a hexagonal wurtzite structure according to Claim 1, wherein the concentration of each of divalent and trivalent metals is 2 ppm or less.

3. The single crystal with a hexagonal wurtzite structure according to Claim 1 or 2, wherein the concentration of each of divalent and trivalent metals is 1.3 ppm or less.

4. A single crystal with a hexagonal wurtzite structure, which is obtained by a crystal growth on at least an m-plane of a columnar seed crystal and is represented by AX (wherein A represents an electropositive element and X represents an electronegative element), wherein the concentration of each of iron (Fe), aluminum (Al) and magnesium (Mg), among metals other than the electropositive element A, is 10 ppm or less, and a variation in the concentration of each of iron (Fe), aluminum (Al) and magnesium (Mg) is within 100%.

5. The single crystal with a hexagonal wurtzite structure according to any one of Claims 1, 2 and 4, wherein the concentration of iron (Fe) is 1.3 ppm or less.

6. The single crystal with a hexagonal wurtzite structure according to any one of Claims 1 to 5, wherein the concentration of aluminum (Al) is 0.5 ppm or less.

7. The single crystal with a hexagonal wurtzite structure according to any one of Claims 1 to 6, wherein the concentration of magnesium (Mg) is 0.1 ppm or less.

8. The single crystal with a hexagonal wurtzite structure according to any one of Claims 1 to 7, wherein a variation in the concentration of a metal other than the electropositive element A and having a concentration of from 0.1 ~ 50 ppm, is within 100%.

9. The single crystal with a hexagonal wurtzite structure according to any one of Claims 1 to 8, wherein the single crystal with a hexagonal wurtzite structure is a zinc oxide single crystal.

10. The single crystal with a hexagonal wurtzite structure according to any one of Claims 1 to 9, which is obtained by using a crystal formation apparatus having a raw material filling portion and a crystal growth portion, lowering the temperature of the crystal growth portion by at least 35°C than the temperature of the raw material filling portion, and effecting a crystal growth at the crystal growth portion.

11. The single crystal with a hexagonal wurtzite structure according to any one of Claims 1 to 10, which is obtained by effecting the crystal growth by Solvo-thermal method.

12. The single crystal with a hexagonal wurtzite structure according to Claim 10 or 11, which is obtained by using a crystal formation apparatus having an inner cylinder made of an anticorrosive metal including platinum or iridium and effecting a crystal growth in the inner cylinder made of an anticorrosive metal.

13. A single crystal with a hexagonal wurtzite structure, which is obtained by a crystal growth on at least an m-plane of a columnar seed crystal and is represented by AX (wherein A represents an electropositive element and X represents an electronegative element), wherein a variation in the concentration of a metal other than the electropositive element A and having a concentration of 0.1 ~ 50 ppm is within 100%.

14. The single crystal with a hexagonal wurtzite structure according to Claim 13, wherein the concentration of each of divalent and trivalent metals, among metals other than the electropositive element A, is 10 ppm or less.

15. The single crystal with a hexagonal wurtzite structure according to Claim 14, wherein the concentration of each of iron (Fe) and aluminum (Al) is 2 ppm or less.

16. A production process of a single crystal with a hexagonal wurtzite structure as claimed in any one of Claims 1 to 9 and 13 to 15, which comprises using a crystal formation apparatus having a raw material filling portion and a crystal growth portion, lowering the temperature of the crystal growth portion by at least 35°C than the temperature of the raw material filling portion, and effecting a crystal growth of the single crystal with a hexagonal wurtzite structure at the crystal growth portion.

17. The production process of a single crystal with a hexagonal wurtzite structure according to Claim 16, wherein the crystal growth is effected by Solvo-thermal method.

18. The production process of a single crystal with a hexagonal wurtzite structure according to Claim 16 or 17, wherein a crystal formation apparatus having an inner cylinder made of an anticorrosive metal including platinum or iridium is used and the crystal growth is effected in the inner cylinder made of an anticorrosive metal.

19. A single crystal substrate with a hexagonal wurtzite structure which has a substantial a-plane or substantial m-plane in the surface thereof and is represented by AX (wherein A represents an electropositive element and X represents an electronegative element), wherein a concentration of each of divalent and trivalent metals, among metals other than the electropositive element A, is 10 ppm or less, and a variation in the concentration of each of divalent and trivalent metals is within 100%.

20. The single crystal substrate with a hexagonal wurtzite structure according to Claim 19, wherein the concentration of each of divalent and trivalent metals is 2 ppm or less.

21. The single crystal substrate with a hexagonal wurtzite structure according to Claim 19 or 20, wherein the concentration of each of divalent and trivalent metals is 1.3 ppm or less.

22. A single crystal substrate with a hexagonal wurtzite structure which has a substantial a-plane or a substantial m-plane in the surface thereof and is represented by AX (wherein A represents an electropositive element and X represents an electronegative element), wherein the concentration of each of iron (Fe), aluminum (Al) and magnesium (Mg), among metals other than the electropositive element A, is 10 ppm or less and a variation in the concentration of each of iron (Fe), aluminum (Al) and magnesium (Mg) is within 100%.

23. The single crystal substrate with a hexagonal wurtzite structure according to any one of Claims 19, 20 and 22, wherein the concentration of iron (Fe) is 1.3 ppm or less.

24. The single crystal substrate with a hexagonal wurtzite structure according to any one of Claims 19 to 23, wherein the concentration of aluminum (Al) is 0.5 ppm or less.

25. The single crystal substrate with a hexagonal wurtzite structure according to any one of Claims 19 to 24, wherein the concentration of magnesium (Mg) is 0.1 ppm or less.

26. The single crystal substrate with a hexagonal wurtzite structure according to any one of Claims 19 to 25, wherein the single crystal with a hexagonal wurtzite structure is zinc oxide single crystal.

27. A single crystal substrate with a hexagonal wurtzite structure which has a substantial a-plane or a substantial m-plane in the surface thereof and is represented by AX (wherein A represents an electropositive element and X represents an electronegative element), wherein a variation in the concentration of a metal other than the electropositive element A and having a concentration of from 0.1 to 50 ppm in the a-plane or m-plane, is within 100%.

28. A single crystal substrate with a hexagonal wurtzite structure, which is obtained by cutting out the single crystal with a hexagonal wurtzite structure as claimed in any one of Claims 1 to 15.

# FIG. 1(a)  FIG. 1(b)

# FIG. 1(c)

○ : A atom
◉ : X atom

# FIG. 2(a)     FIG. 2(b)

## FIG. 3

a-PLANE

+c

a1
a2
a3

-c

m-PLANE

+c

m1
m2
m3

-c

## FIG. 4

a AXIS

a-PLANE

a AXIS

m-PLANE

a AXIS

## FIG. 5

POSITION OF
SEED CRYSTAL

m-PLANE

+c1 +c2 +c3

+c

-c

-c1 -c2 -c3

POSITION OF
SEED CRYSTAL

POSITION OF
SEED CRYSTAL

# FIG. 6

SKETCH OF
GROWN CRYSTAL

+c

-c

m-PLANE

SAMPLE CHIP CUT
FROM m-PLANE

+c

☐ N-1

☐ N-2

☐ N-3

-c

EXAMPLE 2

OVERHEAD CROSS-SECTIONAL
VIEW OF THE SKETCH

SEED CRYSTAL
(m-PLATE)

m-PLANE

EP 1 816 240 A1

# FIG. 7

SKETCH OF
GROWN CRYSTAL

+c

-c

m-PLANE

OVERHEAD CROSS-SECTIONAL
VIEW OF THE SKETCH

SEED CRYSTAL
(m-PLATE)

m-PLANE

SAMPLE CHIP CUT
FROM m-PLANE

+c

-c

O-1   O-3
O-2   O-4

EXAMPLE 3

EP 1 816 240 A1

### INTERNATIONAL SEARCH REPORT

| International application No. |
|---|
| PCT/JP2005/017398 |

| A. CLASSIFICATION OF SUBJECT MATTER |
|---|
| *C30B29/16* (2006.01), *C30B7/10* (2006.01) |

According to International Patent Classification (IPC) or to both national classification and IPC

| B. FIELDS SEARCHED |
|---|
| Minimum documentation searched (classification system followed by classification symbols)<br>*C30B29/16* (2006.01), *C30B29/38* (2006.01), *C30B7/10* (2006.01) |

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)
WPI(DIALOG), JSTPlus(JOIS)

| C. DOCUMENTS CONSIDERED TO BE RELEVANT | | |
|---|---|---|
| Category* | Citation of document, with indication, where appropriate, of the relevant passages | Relevant to claim No. |
| X | JP 2003-221298 A (Tokyo Denpa Kabushiki Kaisha),<br>05 August, 2003 (05.08.03),<br>Claims 1 to 7; Par. Nos. [0006], [0023] to [0029], [0031] to [0032]<br>(Family: none) | 1-28 |
| A | JP 6-90034 A (NGK Insulators, Ltd.),<br>29 March, 1994 (29.03.94),<br>Full text<br>& EP 587407 A2 & US 5393444 A | 1-28 |
| A | JP 6-279190 A (NGK Insulators, Ltd.),<br>04 October, 1994 (04.10.94),<br>Full text<br>(Family: none) | 1-28 |

| ☐ Further documents are listed in the continuation of Box C. | ☐ See patent family annex. |
|---|---|

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>11 October, 2005 (11.10.05) | Date of mailing of the international search report<br>25 October, 2005 (25.10.05) |
|---|---|
| Name and mailing address of the ISA/<br>Japanese Patent Office | Authorized officer |
| Facsimile No. | Telephone No. |

Form PCT/ISA/210 (second sheet) (April 2005)

24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6090036 A
- JP 2003221298 A
- JP 2004290641 A
- JP 2005233202 A

**Non-patent literature cited in the description**

- **NOBORU SAKAGAMI ; MASANOBU WADA.** Growth kinetics and morphology of hydrothermal ZnO single crystal. *Journal of the Ceramic Association,* 1974, vol. 82 (8
- **E. OSHIMA et al.** *Journal of Crystal Growth,* 2004, vol. 260, 166-170